(19) Europäisches Patentamt
European Patent Office
Office européen des brevets

(11) EP 4 105 757 A1

(12) EUROPEAN PATENT APPLICATION
published in accordance with Art. 153(4) EPC

(43) Date of publication:
21.12.2022 Bulletin 2022/51

(21) Application number: 21870835.2

(22) Date of filing: 27.05.2021

(51) International Patent Classification (IPC):
G05F 1/56 (2006.01)          G01J 5/12 (2006.01)

(52) Cooperative Patent Classification (CPC):
G01J 5/12; G01J 5/14; G05F 1/56; H03M 1/12

(86) International application number:
PCT/CN2021/096381

(87) International publication number:
WO 2022/062448 (31.03.2022 Gazette 2022/13)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 22.09.2020 CN 202011000336

(71) Applicant: CSMC Technologies Fab2 Co., Ltd.
Wuxi, Jiangsu 214028 (CN)

(72) Inventors:
• LI, Chen
Wuxi New District, Jiangsu 214028 (CN)
• WANG, Hao
Wuxi New District, Jiangsu 214028 (CN)

(74) Representative: Patentship
Patentanwaltsgesellschaft mbH
Elsenheimerstraße 65
80687 München (DE)

(54) **ANALOG-TO-DIGITAL CONVERTER AND THERMOPILE ARRAY**

(57) An analog-to-digital converter and a thermopile array are disclosed. The analog-to-digital converter includes a reference voltage generation circuit. The reference voltage generation circuit includes: a voltage generation unit (110); a chopper modulation unit (120) configured to perform chopper modulation on a voltage signal generated by the voltage generation unit, which modulates low-frequency noise in the voltage signal into high-frequency noise; and a low-pass filter (130) configured to eliminate the high-frequency noise to obtain a reference voltage. The invention employs a simple structure to obtain a low noise reference voltage at low costs.

Fig. 2

EP 4 105 757 A1

# Description

## CROSS REFERENCE TO RELATED APPLICATION

This application claims priority to Chinese Patent Application No. 202011000336X, filed with China National Intellectual Property Administration on September 22, 2020, entitled "Analog-to-Digital Converter and Thermopile Array", the entirety of which is incorporated herein by reference.

## TECHNICAL FIELD

The present invention relates to analog-to-digital conversion and, in particular, to an analog-to-digital converter (ADC), as well as to a thermopile array.

## BACKGROUND

The statements in this section merely provide background information related to the present application and does not necessarily constitute prior art.

Far infrared thermal sensors are being used in more and more applications, from industrial control to consumer electronics, smart buildings, Internet of Things, etc. The vigorous development of the consumer market brings about a need for more far infrared thermal sensors and for a higher degree of integration thereof. Therefore, further improvements in terms of size and cost are necessary for such sensors. A thermopile sensor is typically composed of many thermocouples connected usually in series (or, less commonly, in parallel). An output voltage of the series-connected depends on the difference between a thermocouple junction temperature and a reference junction temperature. This is known as the Seebeck effect. With the upgrading of technology and market, thermopile infrared sensors have gradually evolved from the early single-pixel structures to sensors in the form of arrays.

As signals from thermopiles are extremely weak, analog-to-digital converters (ADC) for this purpose are imposed with extremely high noise floor requirements, and the noise characteristics of reference sources are critical to the performance of such high-precision ADCs.

## SUMMARY

In view of this, it is necessary to provide an ADC and thermopile array with low noise in a reference voltage.

An ADC used in a thermopile array includes a reference voltage generation circuit. The reference voltage generation circuit includes: a voltage generation unit; a chopper modulation unit configured for chopper modulation of a voltage signal generated by the voltage generation unit, which modulates low-frequency noise in the voltage signal into high-frequency noise; and a low-pass filter configured to eliminate the high-frequency noise, resulting in a reference voltage.

A thermopile array includes: a plurality of sensor pixel elements; and a readout circuit including a plurality of signal processing channels. Each of the signal processing channels includes: a pre-amplifier for amplifying a sensor signal, wherein the pre-amplifier is a single-stage amplifier; and an ADC with an input terminal connected to an output terminal of the pre-amplifier, wherein the ADC is the ADC as defined in the preceding paragraph and is a delta-sigma ADC. Each of the signal processing channels is configured to process sensor signals from $i$ ones of the sensor pixel elements, where $i$ is a positive integer and, when the number of the sensor pixel elements is not smaller than 256, is not greater than one fourth the square root of the number of the sensor pixel elements in the thermopile array.

Details of one or more embodiments of the present invention are set forth in the following drawings and detailed description. Other features, objects and advantages of the present invention will become apparent from the description, drawing and claims.

## BRIEF DESCRIPTION OF THE DRAWINGS

In order to better describe and illustrate embodiments and/or examples of those inventions disclosed herein, reference may be made to one or more accompanying drawings. The additional details or examples used to describe the accompanying drawings should not be considered as limitations to the scope of any of the disclosed inventions, the presently described embodiments and/or examples, and the presently understood best mode of these inventions.

Fig. 1 is a schematic diagram showing the structure of a signal processing channel according to an embodiment;
Fig. 2 is a block diagram of a reference voltage generation circuit according to an embodiment;
Fig. 3 is a block diagram of the reference voltage generation circuit according to another embodiment;
Fig. 4 is a schematic circuit diagram of a low-pass filter according to an embodiment;
Fig. 5 schematically illustrates connection of signal processing channels with sensor pixel elements according to an embodiment;
Fig. 6 schematically illustrates simultaneous gating of a plurality of sensor pixel elements to a single signal processing channel according to an embodiment;
Fig. 7 is a block diagram of a first-order feedback delta-sigma modulator; and
Fig. 8 schematically illustrates how a dynamic input range of an ADC can be adjusted by adjusting its positive and negative reference voltages.

## DETAILED DESCRIPTION

Objects, features and advantages of the present invention will become more apparent upon reading the following more detailed description, which is set forth by way of particular embodiments with reference to the accompanying drawings. It is to be noted that the particular embodiments disclosed herein are intended to be merely illustrative, but not limiting, of the present invention.

Unless defined otherwise, all technical and scientific terms used herein have the same meaning as commonly understood by one of ordinary skill in the art to which this invention belongs. The terminology used herein is for the purpose of describing particular embodiments only and is not intended to be limiting of this invention. As used herein, the term "and/or" includes any and all combinations of one or more of the associated listed items.

It is to be noted that when an element is referred to as being "fixed to" another element, it can be directly on the other element, or intervening elements may also be present. When an element is considered as being "connected to" another element, it can be directly connected to the other element, or intervening elements may also be present. As used herein, the terms "vertical", "horizontal", "upper", "lower", "left", "right" and the like are merely illustrative. When an element or a layer is referred to as being "on", "adjacent to", "connected to" or "coupled to" another element or layer, it can be directly on, adjacent to, or connected or coupled to the other element or layer, or intervening elements or layers may also be present. In contrast, when an element is referred to as being "directly on", "directly adjacent to", "directly connected to" or "directly coupled to" another element, there are no intervening elements or layers present. It will be understood that although the terms first, second, third, etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of the present invention.

The terms "comprises" and/or "comprising", when used in this specification, specify the presence of stated features, integers, steps, operations, elements, and/or components, but do not preclude the presence or addition of one or more other features, integers, steps, operations, elements, components, and/or groups thereof. The singular forms "a", "an" and "the" are intended to include the plural forms as well, unless the context clearly indicates otherwise.

During the continuing development of thermopile infrared sensor arrays, signal processing in thermopile sensors have inevitably encountered the problems detailed below.

Signal readout circuits for mainstream thermopile arrays use pre-amplifiers in combination with high-precision analog-to-digital converters (ADCs) for signal processing. Both the pre-amplifiers and the ADCs require relatively large areas and consume much power to ensure desirable performance. For small arrays (e.g., $2\times2$ or $4\times4$) with relatively large sensor pixel elements and high signal strength, a signal processing chip can provide a sufficient space to accommodate the high-performance pre-amplifiers and ADCs. However, for larger arrays ($>16\times16$) with significantly smaller pixel elements, it would be difficult for the signal processing chip to accommodate a correspondingly larger number of signal processing channels. Moreover, more signal processing channels means increased power consumption. Apart from the current consumption of the channels themselves, more importantly, the large currents through them will lead to self-heating of the chip, which is significantly detrimental to sensor calibration and may thus greatly degrade the thermopile sensor's temperature resolution and reliability. A signal readout circuit for a thermopile array often employs pre-amplifiers with a very high gain which is typically greater than 10,000. Each pre-amplifier is typically followed by a low-pass filter for removing high-frequency noise, which is in turn followed by a high-performance ADC for converting an amplified signal to its digital representation and then outputting the digital signal. In order to ensure good performance, a large area and high power consumption are necessary.

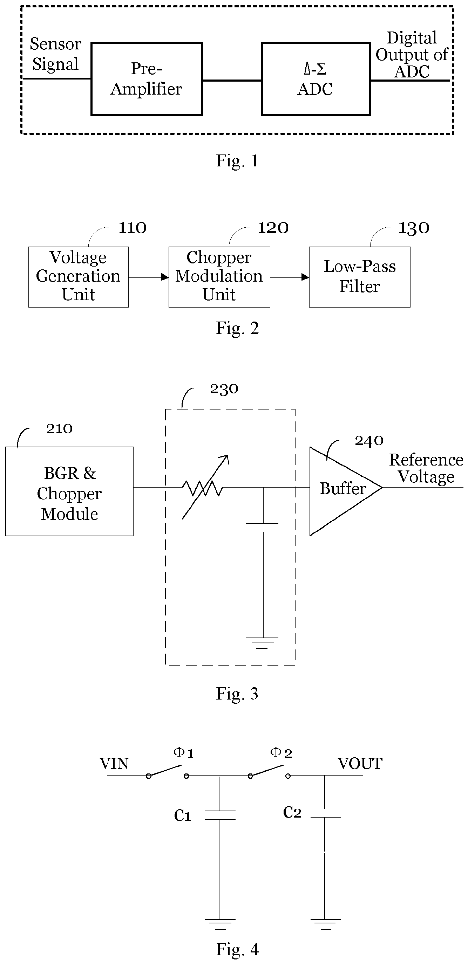

This application provides a thermopile array, in particular a thermopile infrared sensor array, which includes a plurality of sensor pixel elements and a readout circuit (ROIC). The ROIC includes a plurality of signal processing channels. Fig. 1 is a schematic diagram showing the structure of one of the signal processing channels according to an embodiment. Each of the signal processing channels includes a pre-amplifier and an ADC. The pre-amplifier is configured to amplify a sensor signal. In the embodiment shown in Fig. 1, the pre-amplifier is a single-stage amplifier. An input terminal of the ADC is connected to an output terminal of the pre-amplifier. In the embodiment shown in Fig. 1, the ADC is a delta-sigma ADC. Each signal processing channel is configured to process sensor signals output from i sensor pixel elements (i.e., sensor pixel points), where i is a positive integer that is, when the number of the sensor pixel elements in the thermopile array is not less than 256, not greater than one fourth the square root of the number of the sensor pixel elements in the thermopile array. As would be appreciated, this embodiment is mainly for use in a large array, wherein the greater the size of the array, the greater the value of i. When the number of the sensor pixel elements in the thermopile array is less than 256, i.e., for a small array, it may be configured that each signal processing channel processes sensor signals output from a plurality ones of the sensor pixel elements.

In the above thermopile array, a sufficient number of parallel signal processing channels are arranged in accordance with the number of the sensor pixel elements. This results in a significantly extended data processing time for each single signal processing channel, a low frequency at which both the pre-amplifiers and the ADCs can operate to meet the system requirements, an effectively reduced noise bandwidth and hence an effectively increased signal-to-noise ratio of the signal processing channels and significantly improved thermal temperature resolution. Additionally, the lower frequency results in reductions in both area and power consumption of the pre-amplifiers and ADCs. Since the number of signal processing channels is increased to a value sufficient for the signal processing channels to provide a greatly increased integral processing time to each sensor signal from any sensor pixel element, the noise bandwidth is significantly reduced. Since the pre-amplifiers function mainly for noise suppression, preliminary signal amplification and the provision of a certain driving effect, lesser stringent requirements can be imposed on its amplification accuracy. For this reason, in order to control the area of the ROIC, the pre-amplifiers may be implemented as ones with a low closed-loop gain (e.g., single-stage amplifiers). This can result in significant reductions in power consumption and area, thus reducing difficulties in the design of related analog circuits (e.g., those of the pre-amplifiers and the ADCs). The signal processing channels are allowed to operate at a significantly lower current, thus effectively overcoming the problem of self-heating that may be caused by a large operating current and significantly reducing the requirements for temperature calibration of the system. Due to a low closed-loop gain factor of the pre-amplifiers, the ADCs may be based on a delta-sigma architecture, which features a delta-sigma signal transfer function possessing low-pass properties and thus dispenses with the need to arrange low-pass filters between the pre-amplifiers and the ADCs.

For the purpose of low-frequency noise suppression, a reference voltage source typically employs a special low-noise device or a device with a larger area. This makes it extremely expensive.

In order to overcome this, the present application provides an analog-to-digital converter (ADC) usable in the thermopile array as discussed above. The ADC includes a reference voltage generation circuit. Fig. 2 is a block diagram of the reference voltage generation circuit according to an embodiment. The reference voltage generation circuit includes a voltage generation unit 110, a chopper modulation unit 120 and a low-pass filter 130. Since sensor signals output from the sensor pixel elements in the thermopile array are extremely weak (on the order of nV), the ADC is imposed with extremely demanding noise floor requirements, and the noise characteristics of the reference source are crucial to the performance of the high-precision ADC. In order to meet the requirements of applications of the thermopile array, the voltage generation unit 110 is implemented as a low-noise voltage source such as a low-noise bandgap voltage reference (BGR). The chopper modulation unit 120 is configured for chopper modulation of a voltage signal produced by the voltage generation unit 110, which modulates low-frequency noise in the voltage signal (e.g., 1/f noise) into high-frequency noise. The signal is then provided to the low-pass filter 130, which eliminates the high-frequency noise, resulting in a reference voltage. The chopper modulation unit 120 may be implemented as a chopper modulator known in the art and, therefore, needs not be described in further detail herein.

In this ADC, the chopper modulation unit 120 modulates low-frequency noise in the voltage signal produced by the voltage generation unit 110 into high-frequency noise, and the low-pass filter 130 then filters outs the high-frequency noise, thus resulting in the reference voltage. In this way, the low-noise reference voltage can be obtained with a simple structure at low cost.

In one embodiment, a cutoff frequency of the low-pass filter 130 is not higher than 100 Hz.

Since sensor signals output from the sensor pixel elements in the thermopile array are extremely weak and remain weak even after being amplified by the pre-amplifiers, the ADC is allowed to operate at a low voltage and thus consumes less power. In one embodiment, the ADC includes a low dropout regulator (LDO) which provides the ADC with an operating supply voltage LDO adjustable within the range of from 0.9 V to 1.8 V. In one embodiment, the operating supply voltage for the ADC is lower than 1.2 V. The ADC includes a bipolar junction transistor (BJT) with a base-to-emitter voltage Vbe (about 0.7 V) which serves as the voltage signal produced by the voltage generation unit 110. That is, the reference source uses Vbe in lieu of the aforementioned BGR voltage. This can result in effectively reduced power consumption of the ADC.

Fig. 3 is a block diagram of the reference voltage generation circuit according to another embodiment, which includes a BGR and chopper module 210, a first-order cutoff-frequency-adjustable low-pass filter 230 and a buffer 240, which are connected end-to-end. An output terminal of the BGR and chopper module 210 is connected to an input terminal of the first-order cutoff-frequency-adjustable low-pass filter 230, and an output terminal of the first-order cutoff-frequency-adjustable low-pass filter 230 is connected to an input terminal of the buffer 240. The low-noise BGR is implemented as a conventional chopper modulator which modulates low-frequency 1/f noise into high-frequency, and the low-pass filter then eliminates the high-frequency noise. A reference voltage is responsively output from the buffer 240. The low-pass filter is a first-order filter with a cutoff frequency that is adjustable within 100 Hz. In one embodiment, a voltage generated by the low-noise BGR is about 1.2 V.

The cutoff frequency of the first-order cutoff-frequency-adjustable low-pass filter 230 of Fig. 3 is given by $1/(2\pi*RC)$. Therefore, in order to obtain a sufficiently low cutoff frequency, it is necessary to include a large resistor or capacitor. In order to reduce an area occupied by the resistor or capacitor, in one embodiment of this application, a variable resistor in the first-order cutoff-frequency-adjustable low-pass filter 230 is replaced with a switched-capacitor circuit. As shown in Fig. 4, the low-pass filter includes a resistor unit and a filter capacitor C2. The switched-capacitor circuit is included in the resistor unit and includes a capacitor C1, a switch Φ1 and a switch Φ2. The switch Φ1 and the switch Φ2 are alternatively "ON" and "OFF". That is, when the switch Φ1 is closed, the switch Φ2 is opened; and when the switch Φ1 is opened, the switch Φ2 is closed. An equivalent resistance of the switched-capacitor circuit is given by R=1/FC (where, F is a clock frequency, and C is a capacitance of CI). Therefore, replacing the variable resistor with the switched-capacitor circuit can effectively reduce the area occupied by the resistor or capacitor, and the cutoff frequency of the low-pass filter can be precisely controlled by adjusting the clock frequency for the switch Φ1 and the switch Φ2.

When there are a small number of pixels in the thermopile array, an exemplary signal conditioning circuit may employ a multiplexer (MUX) for multiplexing multiple signals into a single or several signal processing channels in a time-divided manner at the expense of a compromised processing time for each pixel element, i.e., an increased noise bandwidth per pixel. This leads to subpar performance when the pixel array is large. The earliest commercially available thermopile infrared sensor arrays had only one or a few pixels (e.g., $8\times8$ or $16\times16$ pixels) each having a quite large size (e.g., 150-300 $\mu$m$\times$150-300 $\mu$m). Therefore, an associated sensor chip could provide a sufficient space to accommodate the several amplifiers or low-pass filters arranged beside the thermopile sensor array. A thermopile sensor array with a greater number of pixels requires the pixels to be scaled down to have a side length of 100 $\mu$m or even 25 $\mu$m. However, a signal produced by a pixel element is proportional to a surface area thereof. This means, if a pixel is reduced in size by half, then the strength of a signal it produce that requires further processing will be reduced to one-fourth. In principle, it is feasible to scale down thermopile cells (thermoelectric pixels) and arrange more such pixels on a single sensor chip, e.g., $16\times16$, $32\times32$, $64\times64$, $128\times128$ or more thermopile pixels. Accordingly, signal voltages from the individual thermopile pixels will need to be multiplexed using $M\times N$ addressing and multiplexer (MUX) switches, i.e., routed onto a common serial signal line. Alternatively, each row or each column is accessed through a common serial interface. As integration of array sensors increases, pixel-to-pixel pitches have significantly decreased, leading to significantly increased sensor output impedance and significantly reduced signal strength. Consequently, signal-to-noise ratios (SNR) of systems are significantly reduced due to noise in devices and circuit. Compared with the early single-pixel thermopile sensors, at a given frame rate, an array sensor with a larger array size will have more signals to be processed, and its signal processing circuit is thus imposed with much stricter bandwidth, gain and other performance requirements.

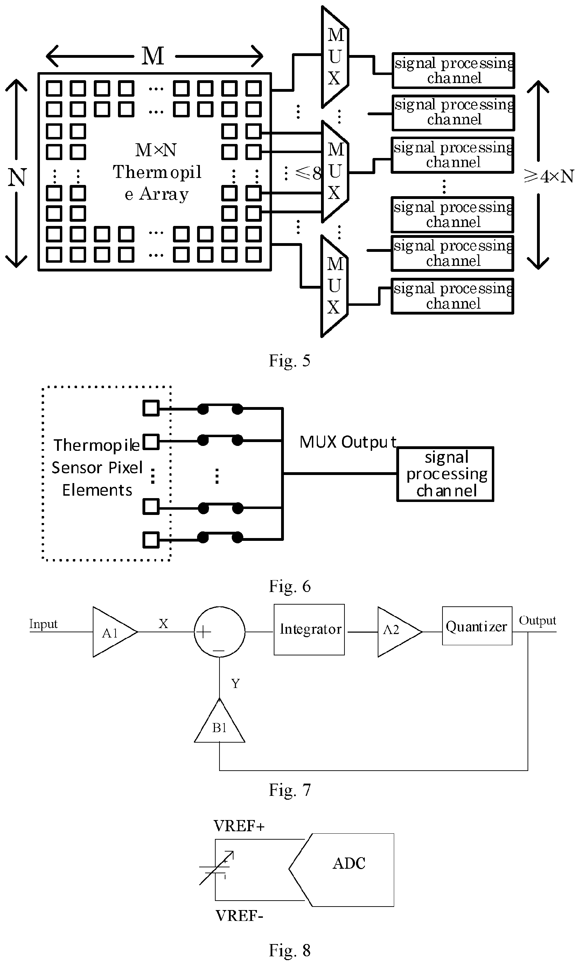

Fig. 5 schematically illustrates connection of signal processing channels with sensor pixel elements according to an embodiment. In this embodiment, the sensor pixel elements are arranged into an $M\times N$ array. In order to ensure desirable thermal temperature resolution and conversion rate of the thermopile array, each signal processing channel is connected to at most eight of the sensor pixel elements by an associated multiplexer, and each sensor pixel element is connected to only one of the signal processing channels. The number of the signal processing channels is at least four times that of rows in the array.

In another embodiment, the multiplexers are omitted, and the number of signal processing channels is equal to that of sensor pixel elements. Moreover, the signal processing channels are in one-to-one correspondence with the respective sensor pixel elements. That is, each signal processing channel is configured for conditioning of a sensor signal from a respective one of the sensor pixel elements. Omitting the multiplexers can result in chip area savings and a simplified design.

As multiple signal processing channels are included, each single signal processing channel has a significantly improved data processing time. For example, in case of a $32\times32$ thermopile array, in order to maintain an array conversion rate of 15 frames per second, assuming each signal processing channel utilizes a multiplexer for input signal multiplexing, then its pre-amplifiers and ADCs must have a conversion rate that is higher than $15\times32\times32$=15 kHz. In contrast, in the embodiment of this application with each sensor pixel element being associated with a separate signal processing channel, the system requirements can be satisfied only with a conversion rate of 15 Hz of the pre-amplifiers and ADCs. The extended conversion time allows a noise bandwidth of the signal processing channels to be significantly reduced (from 15 kHz to 15 Hz), resulting in an effectively improved signal-to-noise ratio of the signal processing channels. Moreover, the reduced frequency results in significant reductions in area and power consumption of the pre-amplifiers and ADCs.

Traditional signal readout circuits for thermopiles were imposed with extremely high pre-amplifier and ADC performance requirements in case of a small number of channels. The use of either a correlated double sampling (CDS) technique or a chopping (chopper modulation) technique would introduce great difficulties to design. Coupled with area, power consumption and other factors, it was challenging to satisfy the system requirements. In contrast, according to the present application, the use of a sufficient number of signal processing channels results in an effectively reduced noise bandwidth of the signal channels and hence effectively improved system performance and significantly increased thermal temperature resolution. The use of a sufficient number of channels also reduces difficulties in the design of associated analog circuits. Further, the significant power consumption and area reductions are helpful in the integration of large arrays (>16x16).

In one embodiment, the thermopile array includes at least one multiplexer, each of which has an input terminal connected to more than one sensor pixel element and an output terminal connected to one signal processing channel. Moreover, each individual multiplexer is connected to a separate respective signal processing channel. For each single multiplexer, the connected sensor pixel elements are simultaneously enabled and disabled, allowing sensor signals from these sensor pixel elements when enabled to be combined into the connected respective signal processing channel, thus obtaining enhanced signal strength.

Fig. 6 schematically illustrates simultaneous gating of a plurality of sensor pixel elements to a single signal processing channel according to an embodiment. At a given point of time, switches in the multiplexer are simultaneously opened or closed, allowing sensor signals from the plurality of sensor pixel elements to be combined and driven into the single signal processing channel. An improved signal-to-noise ratio can be obtained from a combination of series- and parallel-connected thermopiles. The embodiment shown in Fig. 6 is not limited to any particular number of sensor pixel elements connected to each multiplexer, and the number may be determined as actually required by the system.

An exemplary thermopile employs an integral or ramp ADC for data conversion. While this structure is relatively simple, its accuracy is closely related to the quality of design and fabrication. Moreover, it occupies a large area and operates at a very slow speed. Therefore, it is difficult for it to guarantee the satisfaction of system requirements. Considering a low closed-loop gain factor of the pre-amplifiers according to embodiments of this application, in one embodiment, the pre-amplifiers are not followed by NYQUIST ADCs such as integral/ramp ADCs. Instead, a high-precision delta-sigma architecture is employed for analog-to-digital conversion. Taking advantage of the low-pass properties of a signal transfer function of the delta-sigma architecture, low-pass filters are dispensed with between the pre-amplifiers and the ADCs.

Traditional ADCs usually have a high dynamic input range. However, since sensor signals output from the sensor pixel elements in the thermopile array are extremely weak and far lower than a dynamic input range of the ADCs even after being amplified by the pre-amplifiers, it is necessary to optimize the ADCs in terms of power consumption and performance. For small-amplitude input signals, lowering the ADCs' dynamic input range enables them to have an effectively increased signal-to-quantization-noise ratio (SQNR). Fig. 7 is a block diagram of a first-order feedback delta-sigma modulator. An input signal passes through a feedforward stage A1, resulting in a signal X. A signal derived from a subtraction operation performed between the signal X and a feedback signal Y is successively processed in an integrator, A2 and a quantizer. After being output, the signal is further passed through a feedback stage B1, resulting in a feedback signal Y. The integrator in Fig. 7 may be a low-order integrator, and the quantizer may be a single-bit quantizer. A dynamic output range of the quantizer in the delta-sigma modulator is determined by the difference between a positive reference voltage VREF+ and a negative reference voltage VREF-, and a dynamic input range of the modulator is related, in addition to the dynamic range of the quantizer, further to both the feedforward factor A1 and the feedback factor B1. For an exemplary ADC, the difference between the positive reference voltage VREF+ and negative reference voltage VREF- is constant, and a dynamic input range of the ADC is adjustable by changing a ratio of B1 to A1. Moreover, the greater the B1/A1 ratio, the higher the dynamic input range.

Considering that fact that sensor signals output from the sensor pixel elements in the thermopile array are extremely weak and remain weak even they have been amplified by the pre-amplifiers, the system's effective temperature resolution can be improved by lowering the ADCs' dynamic input range (because if the weak signals from the thermopile array are not smaller than output signal amplitude of the pre-amplifiers, the lower the dynamic input signal range of the ADCs is, the higher the temperature resolution the system will have). With reference to the above description, one exemplary approach is to obtain a relatively low dynamic input range by reducing the feedback factor B1. However, for a switched-capacitor ADC, a smaller feedback factor B1 means a larger area required by the capacitor. In order to avoid an increase in the capacitor area, in one embodiment of this application, the dynamic input range of the ADC is lowered by reducing the difference between the positive reference voltage VREF+ and the negative reference voltage VREF-, as shown in Fig. 8. In one embodiment, the difference between the positive and negative reference voltages is adjustable within the range of from $\pm 50$ mV to $\pm 200$ mV, enabling adjustability of the ADC's dynamic input range. In one embodiment, the difference can be adjusted by steps of $\pm 50$ mV.

The approach of reducing the difference between the positive and negative reference voltages is in particular suitably usable in low-voltage applications to effectively reduce both system power consumption and design complexity. In one embodiment, the ADC further includes an operational amplifier for amplifying the positive reference voltage. The voltage amplification is accompanied by proportional amplification of reference noise (e.g., of a BGR). Thus, better noise characteristics and hence improved ADC performance can be achieved even when the positive reference voltage is low.

It would be appreciated that, apart from adjusting the difference between the positive and negative reference voltages, the dynamic input range of the ADC may also be conveniently adjusted to effectively improve the system temperature resolution by properly increasing the feedforward factor A1 or decreasing the feedback factor B1.

Because of many parallel signal channels being used, according to this application, each single signal processing channel has a significantly lowered frequency range, which greatly reduces the noise bandwidth requirements on the pre-amplifiers and ADCs. As discussed above, dynamic wide-range adjustability of the ADCs' dynamic input range for improved thermal temperature resolution of the system can be accomplished either by adjusting the difference between the positive and negative reference voltages or by adjusting the feedforward factor A1 or the feedback factor B1. In one embodiment, in order to ensure system stability against the considerable variability of the dynamic input range, the ADCs adopt a first-order single-bit quantizer feedback architecture. This can result in savings in the area and power consumption of the ADCs. Moreover, using the feedback architecture can lead to a simpler circuit design, which facilitates the integration of a large number of signal channels. As a comparative example, a conditioning circuit employing a second- or higher-order delta-sigma architecture for analog-to-digital conversion will have a complicated structure, which is not conducive to large-scale ROIC integration for the thermopile array. In contrast, the simplified first-order delta-sigma ADC can result in significant savings in area and power consumption, which facilitates the integration of a large number of signal channels. In one embodiment, an oversampling ratio of the ADCs is higher than 4096. At such an oversampling ratio, the ADCs' performance depends on an in-band low-frequency noise floor (independent of the signal-to-quantization-noise ratio SQNR), and MODI exhibits a signal-to-noise ratio infinitely close to that of a high-order modulator while being superior in terms of area and power consumption.

At the oversampling ratio (OSR) that is higher than 4096, the influence of thermal noise from a sample capacitor can be significantly reduced, as known from the following formula:

$$E^2{}_T = (1/\mathrm{OSR}) \times kT/C,$$

where $E^2{}_T$ represents thermal noise energy of the sample capacitor, measured in $V^2$, OSR is the oversampling ratio, k is the Boltzmann constant, T is the Kelvin temperature and C is the capacitance. In one embodiment, in order to reduce power consumption and area cost, the ADCs employ element capacitors each with a capacitance of not greater than 100 fF.

In one embodiment, the use of the high oversampling ratio ADC significantly reduces the requirements on an integrator therein. In order for power consumption and area savings to be achieved, an inverter-based integrator can be used in place of an operational transconductance amplifier (OTA)-based integrator as a comparative example. In one embodiment, the inverter-based integrator is suitable for low-voltage (<1.5V) applications. Using the inverter-based integrator in place of the conventional OTA-based integrator can result in effective area and power consumption savings, making it particular suitable for use in low-voltage applications.

For example, for weak analog signals, in order to reduce quantization noise in a high-performance ADC, a dithering signal, usually a dithering clock derived from a pseudo-random algorithm, may be introduced to the ADC in order to boost its performance. This approach will undoubtedly increases circuit complexity, and the introduced dithering signal may affect stability of the ADC system. In order to overcome this, in one embodiment of this application, the ADC further includes a dithering signal generation unit configured to generate a dithering signal at a predetermined frequency and output it to the input terminal of the ADC. The predetermined frequency is adjustable, and once it is set, the generated dithering signal will have a fixed clock cycle until it is adjusted again. For a low-order delta-sigma ADC with the difference between positive and negative reference voltages being small and adjustable, the dithering signal with an adjustable clock cycle will have a minimized influence on the loop stability.

Reference throughout this specification to "some embodiments", "other embodiments", "ideal embodiments" or the like means that a particular feature, structure, material, or characteristic described in connection with the embodiments or examples is included in at least one embodiment or example of the invention. Thus, the appearances of those phrases in various places throughout this specification are not necessarily referring to the same embodiment or example of the invention.

The various technical features of the foregoing embodiments may be combined in any way. Although not all such combinations have been described above for the sake of brevity, any of them is considered to fall within the scope of this specification as long as there is no contradiction between the technical features.

Presented above are merely several embodiments of the present invention. Although these embodiments are described with some particularity and in some detail, it should not be construed that they limit the scope of the present application in any sense. It should be noted that various variations and modifications can be made by those of ordinary skill in the art without departing from the concept of the present application. Accordingly, it is intended that all such variations and modifications are embraced within the scope of this application as defined in the appended claims.

**Claims**

1. An analog-to-digital converter used in a thermopile array, the analog-to-digital converter comprising a reference voltage generation circuit, the reference voltage generation circuit comprising:

a voltage generation unit;
a chopper modulation unit configured to perform chopper modulation on a voltage signal generated by the voltage generation unit, which modulates low-frequency noise in the voltage signal into high-frequency noise; and
a low-pass filter configured to eliminate the high-frequency noise, thereby obtaining a reference voltage.

2. The analog-to-digital converter according to claim 1, wherein the voltage generation unit is a bandgap voltage reference, or wherein the analog-to-digital converter has an operating supply voltage lower than 1.2 V and comprising a bipolar junction transistor, Vbe of the bipolar junction transistor serving as the voltage signal generated by the voltage generation unit.

3. The analog-to-digital converter according to claim 1, wherein the low-pass filter has a cutoff frequency that is not higher than 100 Hz.

4. The analog-to-digital converter according to claim 1, wherein the low-pass filter comprises a resistor unit and a filter capacitor, the resistor unit comprising a switched-capacitor circuit.

5. The analog-to-digital converter according to claim 1, wherein the reference voltage from the reference voltage generation circuit comprises a positive reference voltage and a negative reference voltage, the difference between the positive reference voltage and the negative reference voltage being adjustable within the range from ±50 mV to ±200 mV, thereby enabling the analog-to-digital converter to have an adjustable dynamic input range.

6. The analog-to-digital converter according to claim 1, further comprising a dithering signal generation unit configured to generate a dithering signal at a predetermined frequency and output the dithering signal to an input terminal of the analog-to-digital converter.

7. The analog-to-digital converter according to claim 1, wherein the analog-to-digital converter is a delta-sigma analog-to-digital converter.

8. The analog-to-digital converter according to claim 7, wherein the analog-to-digital converter employs a first-order single-bit quantizer feedback architecture.

9. The analog-to-digital converter according to claim 8, wherein an oversampling ratio of the analog-to-digital converter is greater than 4096, and wherein an integrator in the analog-to-digital converter is an inverter-based integrator.

10. The analog-to-digital converter according to claim 1, wherein the analog-to-digital converter employs an element capacitor with a capacitance that is not greater than 100 fF.

11. A thermopile array, comprising:

a plurality of sensor pixel elements; and
a readout circuit comprising a plurality of signal processing channels each comprising:

a pre-amplifier for amplifying a sensor signal, wherein the pre-amplifier is a single-stage amplifier; and
an analog-to-digital converter with an input terminal connected to an output terminal of the pre-amplifier, wherein the analog-to-digital converter is a delta-sigma analog-to-digital converter and is an analog-to-digital converter as defined in any one of claims 1 to 6;

wherein each of the plurality of signal processing channels is configured to process sensor signals from i ones of the plurality of sensor pixel elements, where i is a positive integer and, when the number of the plurality of sensor pixel elements is not smaller than 256, i is not greater than one fourth the square root of the number of the plurality of sensor pixel elements in the thermopile array, and wherein there is no low-pass filter arranged between the analog-to-digital converter and the pre-amplifier in each of the plurality of signal processing channels.

12. The thermopile array according to claim 11, wherein the number of the plurality of signal processing channels is equal to the number of the plurality of sensor pixel elements, and the plurality of signal processing channels are in one-to-one correspondence with the plurality of sensor pixel elements, or wherein the thermopile array further comprises at least one multiplexer each having an input terminal connected to more than one of the plurality of sensor pixel elements and having an output terminal connected to one of the plurality of signal processing channels so that each multiplexer is connected to a different one of the plurality of signal processing channels, and for each multiplexer, the plurality of sensor pixel elements connected to the specific multiplexer are simultaneously closed or opened to enable sensor signals from the plurality of sensor pixel elements when closed to be combined and delivered into the plurality of signal processing channel connected to the specific multiplexer.

**13.** The thermopile array according to claim 11, wherein the pre-amplifier employs a chopper-stabilized modulation method.

**14.** The thermopile array according to claim 11, wherein at most eight of the plurality of sensor pixel elements are connected to one of the plurality of signal processing channels through one of the multiplexer(s).

**15.** The thermopile array according to claim 11, wherein the plurality of sensor pixel elements are arranged into a sensor array, and wherein the number of the plurality of signal processing channels is at least equal to four times the number of rows in the sensor array.

Sensor
Signal | Pre-Amplifier | Δ-Σ ADC | Digital Output of ADC

Fig. 1

110
Voltage Generation Unit

120
Chopper Modulation Unit

130
Low-Pass Filter

Fig. 2

230

210
BGR & Chopper Module

240
Buffer

Reference Voltage

Fig. 3

VIN Φ1 Φ2 VOUT

C1

C2

Fig. 4

Fig. 5

Fig. 6

Fig. 7

Fig. 8

<h1 style="text-align:center">INTERNATIONAL SEARCH REPORT</h1>

| | |
|---|---|
| | International application No. |
| | **PCT/CN2021/096381** |

**A. CLASSIFICATION OF SUBJECT MATTER**

G05F 1/56(2006.01)i;  G01J 5/12(2006.01)i

According to International Patent Classification (IPC) or to both national classification and IPC

**B. FIELDS SEARCHED**

Minimum documentation searched (classification system followed by classification symbols)

G05F; G01J

Documentation searched other than minimum documentation to the extent that such documents are included in the fields searched

Electronic data base consulted during the international search (name of data base and, where practicable, search terms used)

CNPAT, CNKI, WPI, EPODOC: 华润上华科技, 李琛, 王浩, 模数转换, 基准电压, 电压源, 斩波, 低通滤波, 带隙基准, 电阻, 开关电容电路, 抖动信号, 量化噪声, 反相, 积分, 运算放大, 热电堆, 阵列, 热电偶, 传感器, 像素, 前置放大, 多路复用, 通道, analogue digital converter, ADC, reference, voltage, bandgap, chop+, lowpass, filter??, resistance, capacitance, dither???, pixel???, thermo???, thermocouple, sensor???, multiple+, MUX, SNR

**C. DOCUMENTS CONSIDERED TO BE RELEVANT**

| Category* | Citation of document, with indication, where appropriate, of the relevant passages | Relevant to claim No. |
|---|---|---|
| X | CN 105353817 A (NANJING TIANYI HEXIN ELECTRONIC CO., LTD.) 24 February 2016 (2016-02-24) <br> description, paragraphs [0002]-[0010], and figures 1-3 | 1-3, 5, 7-10 |
| Y | CN 105353817 A (NANJING TIANYI HEXIN ELECTRONIC CO., LTD.) 24 February 2016 (2016-02-24) <br> description, paragraphs [0002]-[0010], and figures 1-3 | 4, 6 |
| Y | 从余 (CONG, Yu). "集成开关电容滤波器及其应用——正弦波发生器 (non-official translation: Integrated Switched-Capacitor Filter and Its Application: Sine Wave Generator)" 《实用电子文摘》 ("Practical Electronics Digest"), No. 09, 30 September 1995 (1995-09-30), ISSN: 1008-7559, <br> page 53 section 1, figure 1 | 4 |
| Y | CN 1317880 A (LUCENT TECHNOLOGIES, INC.) 17 October 2001 (2001-10-17) <br> description, abstract | 6 |
| A | CN 110199181 A (HEIMANN SENSOR GMBH) 03 September 2019 (2019-09-03) <br> entire document | 1-15 |

☑ Further documents are listed in the continuation of Box C.    ☑ See patent family annex.

| | |
|---|---|
| \*   Special categories of cited documents: <br> "A"   document defining the general state of the art which is not considered to be of particular relevance <br> "E"   earlier application or patent but published on or after the international filing date <br> "L"   document which may throw doubts on priority claim(s) or which is cited to establish the publication date of another citation or other special reason (as specified) <br> "O"   document referring to an oral disclosure, use, exhibition or other means <br> "P"   document published prior to the international filing date but later than the priority date claimed | "T"   later document published after the international filing date or priority date and not in conflict with the application but cited to understand the principle or theory underlying the invention <br> "X"   document of particular relevance; the claimed invention cannot be considered novel or cannot be considered to involve an inventive step when the document is taken alone <br> "Y"   document of particular relevance; the claimed invention cannot be considered to involve an inventive step when the document is combined with one or more other such documents, such combination being obvious to a person skilled in the art <br> "&"   document member of the same patent family |

| Date of the actual completion of the international search | Date of mailing of the international search report |
|---|---|
| **11 August 2021** | **30 August 2021** |

| Name and mailing address of the ISA/CN | Authorized officer |
|---|---|
| **China National Intellectual Property Administration (ISA/ CN)** <br> **No. 6, Xitucheng Road, Jimenqiao, Haidian District, Beijing 100088** <br> **China** | |
| Facsimile No. **(86-10)62019451** | Telephone No. |

Form PCT/ISA/210 (second sheet) (January 2015)

**INTERNATIONAL SEARCH REPORT**

| International application No. |
|---|
| **PCT/CN2021/096381** |

### C. DOCUMENTS CONSIDERED TO BE RELEVANT

| Category* | Citation of document, with indication, where appropriate, of the relevant passages | Relevant to claim No. |
|---|---|---|
| A | CN 109471486 A (UNIVERSITY OF ELECTRONIC SCIENCE AND TECHNOLOGY OF CHINA) 15 March 2019 (2019-03-15)<br>entire document | 1-15 |
| A | CN 104901700 A (TSINGHUA UNIVERSITY) 09 September 2015 (2015-09-09)<br>entire document | 1-15 |
| A | CN 104518797 A (NO. 24 RESEARCH INSTITUTE OF CETC) 15 April 2015 (2015-04-15)<br>entire document | 1-15 |
| A | CN 102176188 A (SHANGHAI RESEARCH INSTITUTE OF MICROELECTRONICS (SHRIME), PEKING UNIVERSITY) 07 September 2011 (2011-09-07)<br>entire document | 1-15 |
| A | DE 102010003125 A1 (EXOTRONIC G.M.B.H.) 22 September 2011 (2011-09-22)<br>entire document | 1-15 |

Form PCT/ISA/210 (second sheet) (January 2015)

**INTERNATIONAL SEARCH REPORT**
**Information on patent family members**

International application No.

**PCT/CN2021/096381**

| Patent document cited in search report | | | Publication date (day/month/year) | Patent family member(s) | | | Publication date (day/month/year) |
|---|---|---|---|---|---|---|---|
| CN | 105353817 | A | 24 February 2016 | CN | 105353817 | B | 16 February 2018 |
| CN | 1317880 | A | 17 October 2001 | CA | 2336728 | A1 | 14 September 2001 |
| | | | | DE | 60125851 | T2 | 11 October 2007 |
| | | | | EP | 1134898 | B1 | 10 January 2007 |
| | | | | US | 6268814 | B1 | 31 July 2001 |
| | | | | KR | 100787369 | B1 | 24 December 2007 |
| | | | | JP | 2001267922 | A | 28 September 2001 |
| | | | | KR | 20010092323 | A | 24 October 2001 |
| | | | | DE | 60125851 | D1 | 22 February 2007 |
| | | | | EP | 1134898 | A2 | 19 September 2001 |
| | | | | BR | 0100945 | A | 30 October 2001 |
| | | | | AU | 2645401 | A | 20 September 2001 |
| | | | | JP | 3836328 | B2 | 25 October 2006 |
| | | | | IN | 200100220 | I4 | 28 November 2008 |
| CN | 110199181 | A | 03 September 2019 | JP | 2020505618 | A | 20 February 2020 |
| | | | | US | 10739201 | B2 | 11 August 2020 |
| | | | | DE | 102017102833 | A1 | 19 July 2018 |
| | | | | KR | 20190107698 | A | 20 September 2019 |
| | | | | US | 2020333190 | A1 | 22 October 2020 |
| | | | | US | 2020033195 | A1 | 30 January 2020 |
| | | | | EP | 3571482 | A1 | 27 November 2019 |
| | | | | WO | 2018134288 | A1 | 26 July 2018 |
| CN | 109471486 | A | 15 March 2019 | CN | 109471486 | B | 17 March 2020 |
| CN | 104901700 | A | 09 September 2015 | CN | 104901700 | B | 20 April 2018 |
| CN | 104518797 | A | 15 April 2015 | CN | 104518797 | B | 13 October 2017 |
| | | | | US | 9667267 | B2 | 30 May 2017 |
| | | | | US | 2016373128 | A1 | 22 December 2016 |
| | | | | WO | 2016119133 | A1 | 04 August 2016 |
| CN | 102176188 | A | 07 September 2011 | | None | | |
| DE | 102010003125 | A1 | 22 September 2011 | DE | 102010003125 | B4 | 12 September 2013 |

Form PCT/ISA/210 (patent family annex) (January 2015)

**EP 4 105 757 A1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- CN 202011000336X